Europäisches Patentamt

European Patent Office

Office européen des brevets

(19)

(11) Veröffentlichungsnummer: **0 252 397 B1**

(12) **EUROPÄISCHE PATENTSCHRIFT**

(45) Veröffentlichungstag der Patentschrift: 29.05.91

(51) Int. Cl.⁵: **A61B 17/22**, H03K 3/537

(21) Anmeldenummer: 87109322.5

(22) Anmeldetag: 29.06.87

(54) **Verbindungskabel zwischen einem Impulserzeuger und einem Stosswellengenerator.**

(30) Priorität: 10.07.86 DE 3623277

(43) Veröffentlichungstag der Anmeldung:
13.01.88 Patentblatt 88/02

(45) Bekanntmachung des Hinweises auf die
Patenterteilung:
29.05.91 Patentblatt 91/22

(84) Benannte Vertragsstaaten:
**DE FR GB NL**

(56) Entgegenhaltungen:
**EP-A- 0 142 050**
**GB-A- 689 813**

**INSTRUMENTS AND EXPERIMENTAL TECHNI-
QUES, Nr. 3, Mai-Juni 1970, Seiten 679-682,
Consultants Bureau, a division of Plenum
Publishing Corp., New York, US; B.K. RATNI-
KOV: "Shaping of rectangular field-pulses in
inductance-type driving magnet"**

(73) Patentinhaber: **Siemens Aktiengesellschaft**
**Wittelsbacherplatz 2**
**W-8000 München 2(DE)**

(72) Erfinder: **Reitter, Josef**
**Elsterweg 3**
**W-8521 Möhrendorf(DE)**

EP 0 252 397 B1

Rank Xerox (UK) Business Services

## Beschreibung

Die Erfindung betrifft eine Einrichtung zum Zertrümmern von im Körper eines Lebewesens befindlichen Konkrementen mit einem Verbindungskabel mit einem abgeschirmten Mittelleiter zwischen einem Impulserzeuger und einem Stoßwellengenerator.

Aus der DE-PS 31 46 627 ist ein derartiges Verbindungskabel bekannt, das als HF-Koaxialkabel zwischen dem Impulserzeuger und dem Stoßwellengenerator, einer Unterwasserfunkenstrecke, angeordnet ist. Der Mittelleiter des Koaxialkabels überträgt die Spannung, während die Abschirmung mit der Masse des Impulserzeugers verbunden ist und gleichzeitig den Rückleiter bildet. Da bei der Erzeugung von Stoßwellen kurzzeitig hohe Ströme über das Verbindungskabel fließen, entsteht an diesem ein großer Spannungsabfall, so daß an der Abschirmung im Bereich des Stoßwellengenerators eine große Spannung anliegt, die im Falle einer Berührung durch Personen tödlich sein kann. Deshalb läßt sich auch das Gehäuse des Stoßwellengenerators nicht direkt mit der Abschirmung verbinden.

Die Erfindung geht von der Aufgabe aus, ein Verbindungskabel der eingangs genannten Art zu schaffen, das eine niedrige Induktivität aufweist und bei dem eine potentialfreie Masseverbindung zwischen dem Impulserzeuger und dem Stoßwellengenerator gewährleistet ist.

Die Aufgabe wird erfindungsgemäß dadurch gelöst, daß das Verbindungskabel ein Triaxialkabel ist, das einen Mittelleiter mit zwei konzentrischen Abschirmungen aufweist, bei dem der Mittelleiter und die erste Abschirmung den Hin- und Rückleiter bilden und die zweite Abschirmung beidseitig auf Masse bzw. Gehäuse gelegt ist. Durch diese Anordnung erhält man ein Übertragungskabel für die Stoßwellenimpulse mit geringer Streuinduktivität und eine potentialfreie Abschirmung, die gleichzeitig die Masseverbindung zwischen Impulserzeuger und Stoßwellengenerator herstellt.

Die Spannungsdifferenz zwischen den beiden Gehäusen läßt sich gering halten, wenn der Mittelleiter der Hinleiter und die erste Abschirmung der Rückleiter ist.

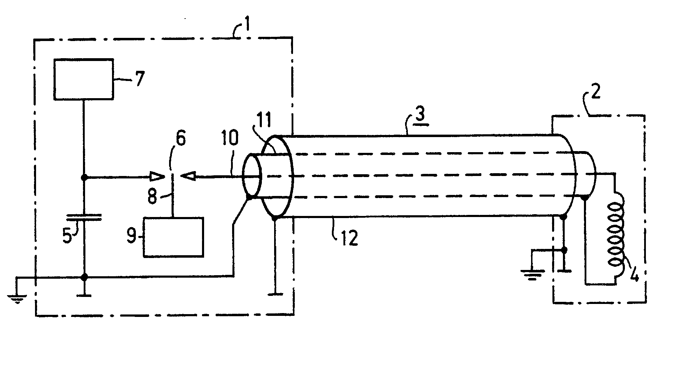

Die Erfindung ist nachfolgend anhand des in der Figur dargestellten Ausführungsbeispieles näher erläutert.

In der Figur ist ein Impulserzeuger 1 dargestellt, der mit einem Stoßwellengenerator 2 über ein Verbindungskabel 3 verbunden ist. Der Stoßwellengenerator 2 ist dabei als bekanntes Stoßwellenrohr ausgeführt. Er umfaßt als wesentliche Komponente eine schematisch dargestellte Primärspule 4, die zusammen mit einer nicht dargestellten Sekundärmembran bei Beaufschlagung mit Impulsen die Stoßwellen zur Zerkleinerung der Konkremente erzeugt. Ein Kondensator 5 wird bei Auslösung einer Funkenstrecke 6 über diese, das Verbindungskabel 3 und die Primärspule impulsartig entladen. Über eine Ladeeinrichtung 7 wird der Kondensator 5 nachgeladen. Die Funkenstrecke 6 weist zu ihrer Zündung eine Hilfselektrode 8 auf, welche an einem Auslösegerät 9 angeschlossen ist, mit dem eine Einzelauslösung von Stoßwellen, eine periodische Folge von Auslösungen oder auch eine herz- und/oder atemgetriggerte Auslösung von Stoßenwellen möglich sind.

Das Verbindungskabel ist als Triaxialkabel mit zwei konzentrischen Abschirmungen ausgebildet. Um einen Mittelleiter 10 des Verbindungskabels 3 ist eine erste Abschirmung 11 konzentrisch angeordnet, die gegenüber dem Mittelleiter 10 isoliert ist. Eine zweite Abschirmung 12 umgibt die erste Abschirmung 11 und den Mittelleiter 10 konzentrisch. Sie ist ebenfalls gegenüber der ersten Abschirmung 11 isoliert. Das gesamte Verbindungskabel 3 ist abschließend von einem Isoliermantel umgeben.

Die Funkenstrecke 6 ist über den Mittelleiter 10 des Verbindungskabels 3 mit der Primärspule 4 als Hinleiter verbunden. Der andere Anschluß der Primärspule 4 ist mit der ersten Abschirmung 11 des Verbindungskabels 3 verbunden, die als Rückleiter dient. Die erste Abschirmung 11 ist im Impulserzeuger 1 mit dem anderen, nicht an der Funkenstrecke 6 angeschlossenen Pol des Kondensators 5 verbunden, der auf Masse gelegt ist. Die zweite Abschirmung 12 des Verbindungskabels 3 ist beidseitig beim Impulserzeuger 1 und dem Stoßwellengenerator 2 mit Masse bzw. den Gehäusen verbunden.

Durch diese Anordnung wird erreicht, daß die elektrischen Impulse zur Stoßwellenerzeugung vom Impulserzeuger 1 zum Stoßwellengenerator 2 durch ein induktivitätsarmes Koaxialkabel, bestehend aus dem Mittelleiter 10 und der ersten Abschirmung 11, übertragen wird. Die zweite Abschirmung dient hierbei als weitere Abschirmung und zur Masseverbindung des Impulserzeugers 1 und des Stoßwellengenerators 2.

## Ansprüche

1. Einrichtung zum Zertrümmern von im Körper eines Lebewesens befindlichen Konkrementen mit einem Verbindungskabel (3) mit einem abgeschirmten Mittelleiter (10) zwischen einem Impulserzeuger (1) und einem Stoßwellengenerator (2), **dadurch gekennzeichnet,** daß das Verbindungskabel (3) ein Triaxialkabel ist, das einen Mittelleiter (10) mit zwei konzentrischen Abschirmungen (11, 12) aufweist, bei dem der Mittelleiter (10) und die erste Abschirmung (11) den Hin- und Rückleiter bilden und die zweite Abschirmung (12) beidseitig auf Masse gelegt ist.

2. Einrichtung nach Anspruch 1, **dadurch gekennzeichnet,** daß der Mittelleiter (10) der Hinleiter und die erste Abschirmung (11) der Rückleiter ist.

## Claims

1. Device for crushing concretions located in the body of a living being with a connection cable (3) with a screened middle conductor (10) between a pulse generator (1) and a shock-wave generator (2), characterized in that the connection cable (3) is a triaxial cable, which has a middle conductor (10) with two concentric screenings (11, 12), in which the middle conductor (10) and the first screening (11) form the forward and return conductor and the second screening (12) is connected to earth on both sides.

2. Device according to claim 1, characterized in that the middle conductor (10) is the forward conductor and the first screening (11) is the return conductor.

## Revendications

1. Dispositif pour fragmenter des concrétions situées dans le corps d'un être vivant et comportant un câble de raccordement (3) équipé d'un conducteur central blindé (10) disposé entre un générateur d'impulsions (1) et un générateur d'ondes de choc (2), caractérisé par le fait que le câble de raccordement (3) est un câble triaxial, qui possède un conducteur central (10) et deux blindages concentriques (11, 12), le conducteur central (10) et le premier blindage (11) constituant les conducteurs aller et retour, tandis que le second blindage (12) est raccordé, des deux côtés, à la masse.

2. Dispositif suivant la revendication 1, caractérisé par le fait que le conducteur central (10) forme le conducteur aller et le premier blindage (11) forme le conducteur retour.